# EUROPÄISCHE PATENTSCHRIFT

(11) **EP 1 276 228 B1**
(45) Veröffentlichungstag und Bekanntmachung des Hinweises auf die Patenterteilung: **21.01.2009**
(21) Anmeldenummer: 02012791.6
(22) Anmeldetag: 10.06.2002
(51) Int. Cl.: H03F 3/08, G01R 15/22, G01D 5/34

(54) **Verfahren und Vorrichtung zur Signalstabilisierung**
Method and apparatus for signal stabilization
Méthode et dispositif pour stabiliser un signal

(30) Priorität: 09.07.2001 DE 10132540
(43) Veröffentlichungstag der Anmeldung: 15.01.2003
(73) Patentinhaber: PWB-Ruhlatec Industrieprodukte GmbH, 99846 Seebach (DE)
(72) Erfinder: Tenca, Vittorio, 37013 Caprino Veronese (VR) (IT); Zanotti, Ernesto, 37057 S. Giovanni Lupatoto (VR) (IT); Bari, Andrea, 37126 Verona (IT); Carradori, Corrado, 37026 Pescantina (VR) (IT)
(74) Vertreter: Müller-Wolff, Thomas

(56) Entgegenhaltungen:
- US-A- 5 130 556
- PATENT ABSTRACTS OF JAPAN Bd. 017, Nr. 040 (P-1475), 26. Januar 1993 (1993-01-26) & JP 04 256837 A (NGK SPARK PLUG CO LTD), 11. September 1992 (1992-09-11)
- PATENT ABSTRACTS OF JAPAN Bd. 007, Nr. 113 (P-197), 18. Mai 1983 (1983-05-18) & JP 58 034367 A (YOKOGAWA DENKI SEISAKUSHO KK), 28. Februar 1983 (1983-02-28)
- PATENT ABSTRACTS OF JAPAN Bd. 1996, Nr. 11, 29. November 1996 (1996-11-29) & JP 08 178618 A (FUJITSU TEN LTD), 12. Juli 1996 (1996-07-12)

## Beschreibung

Die Erfindung betrifft ein Verfahren zur Signalstabilisierung bei optischen Sensoren, die mit LED und einer Taktscheibe/ einen Taktlineal zu einer Sensor/ Emittereinheit zusammengeschaltet sind. Die Erfindung betrifft ferner eine Vorrichtung zur Durchführung des Verfahrens bestehend aus LED, Taktscheibe/ Taktlineal und einer Empfängereinheit.

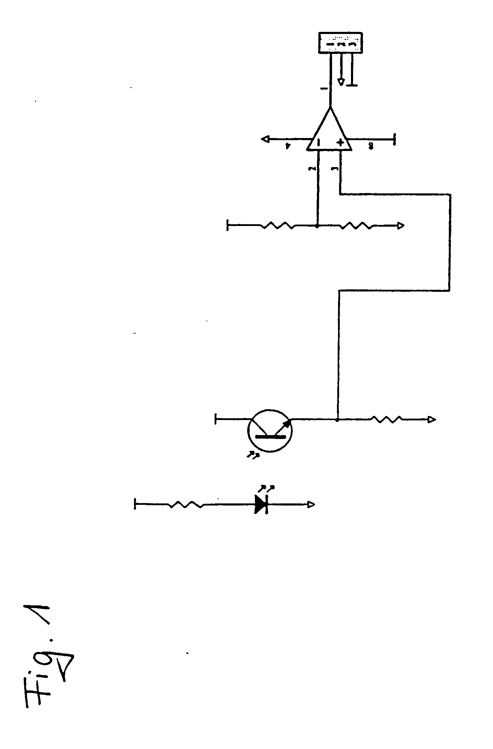

Es ist bekannt, das aus einem Empfänger einer Sensor-Emittereinheit empfangene Signal in einen Verstärker einzuleiten und mit einer Referenzspannung zu vergleichen (siehe Figur 1). Mit der bekannten Einrichtung wird das aus dem Empfänger stammende Analogsignal in ein Rechteckformat umgewandelt (digitalisiert), es kann jedoch nicht entzerrt, geglättet oder normiert werden.

Ein weiteres Beispiel für eine optische Messvorrichtung, welche eine Rückkopplung zur Stabilisierung aufweist ist in JP 4256837 offenbart.

In vielen Anwendungsfällen kommt es darauf an, dass das aus dem Empfänger stammende Signal eine gleichförmige Amplitudenhöhe und gleichmäßige Flankenabstände aufweist. Diese Forderungen lassen sich nur mit aufwendigen und somit teuren optischen Sensoren verwirklichen. Darüber hinaus kann durch Frequenzschwankungen und Alterungserscheinungen die Signalform variieren, so dass es aus folgenden Gründen zu Fehlmessungen kommen kann:
1. Mechanische, optische, physikalisch-elektrische Merkmalsunterschiede der LED
2. Einflüsse der Befestigung und des Aufbaus der LED
3. Ebenheit der Fläche und Genauigkeit der Lagerung der Taktscheibe
4. Alterungseinfluss
5. Taktschwankungen

Aufgabe der vorliegenden Erfindung ist es, die genannten Eigenschaften bei optischen Sensoren zu verbessern und ein Verfahren anzugeben, mit dem auch bei schwankenden Frequenzen oder Alterungserscheinungen an LED und Sensoren sowie bei produktionsbedingten Variationen ein stabiles Signal aus dem Empfänger der Sensoremittereinheit erhalten wird. Gleichzeitig soll eine Vorrichtung angegeben werden, die es unter den gegebenen Umständen ermöglicht, unter Einsatz einfacher Bauteile eine kostengünstige Signalstabilisierung für optische Sensoren zu ermöglichen.

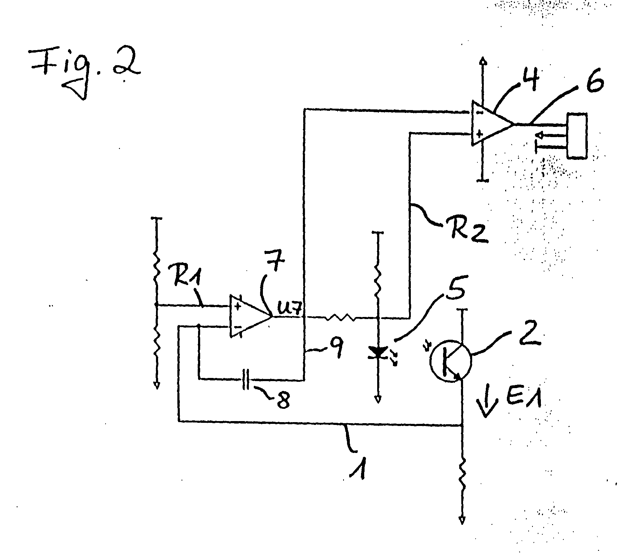

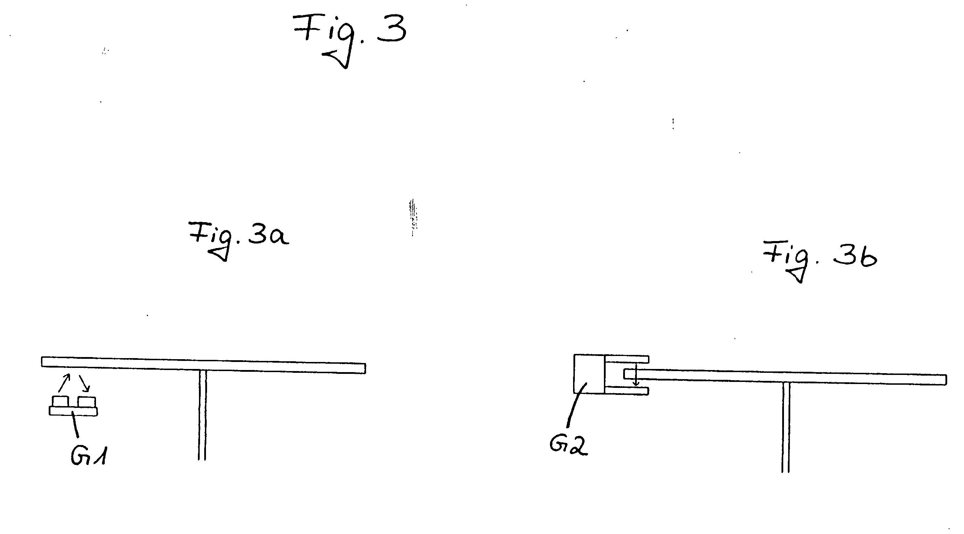

Diese Aufgabe wird erfindungsgemäß durch die in den Patentansprüchen angegebenen Merkmale gelöst. Es hat sich gezeigt, dass durch eine verhältnismäßige einfache Schaltung (Figur 2), nämlich einer Feed-Back-Schleife, das Signal der LED stabilisiert werden kann. Die erfindungsgemäße Vorrichtung besteht aus wenigen einfach aufgebauten elektronischen Bausteinen, die mit geringem Aufwand an bekannte oder bereits im Einsatz befindliche optische Sensoren angeschlossen werden kann ( Figur 3).

Die Erfindung wird im folgenden näher erläutert. Es zeigen:
- Figur 1: optischer Sensor nach dem Stand der Technik
- Figur 2: erfindungsgemäßer Sensor mit LED feedback
- Figur 3: erfindungsgemäß aufgebauter Encoder
- Figur 4: bei einer erfindungsgemäßen Feed-Back-Schaltung Blockschaltbild für die Signalverarbeitung
- Figur 5: verschiedene Kurvenverläufe bei der Signalstabilisierung

Ein bekannter optischer Sensor ist in Figur 1 dargestellt, wobei die LED unabhängig von der Empfängereinheit arbeitet. Das aus dem Empfänger kommende Signal geht an den Pluseingang eines Verstärkers. An den Minuseingang des Verstärkers ist eine Referenzspannung gelegt. Diese Schaltung ermöglicht zwar durch Verschiebung der Referenzspannung eine Korrektur des Signals hinsichtlich der Amplitudenhöhe zu erreichen, jedoch wird hierbei nicht eine Stabilisierung hinsichtlich Frequenz und Phasenverlauf erreicht, sondern des Signal wird von analog in digital umgewandelt.

In Figur 2 ist nun die erfindungsgemäße Schaltung zur Stabilisierung des optischen Sensors dargestellt. Die aus dem Empfänger abgehende Leitung wird an dem Minuspol des Verstärkers angeschlossen, während an dem Pluspol die Referenzspannung liegt. Die Differenz zwischen der Referenzspannung und der aus dem Empfänger abgeleiteten Spannung wird über einen Widerstand R3 an die LED zurückgeführt. Die LED hat - wie im Stand der Technik bereits vorhanden - einen Vorschaltwiderstand R4, dessen Widerstandswert jedoch von 220 Ohm auf 1200 Ohm erhöht wurde. Dadurch wird erreicht, dass die normale Stromversorgung der LED über die Leitung 7 des ersten Verstärkers erfolgt.

In Figur 3 sind die Bauteile des neuen Encoders dargestellt. Figur 3a zeigt einen Encoder mit Reflektionsschicht, so dass LED und Photosensor auf einer Seite der Taktscheibe angeordnet sind. Die erfindungsgemäße Schaltung zur Stabilisierung des Signals befindet sich in der Grundplatte G1.

In Figur 3b ist der Encoder mit einer transparenten Taktscheibe dargestellt. LED und Photosensor sind jeweils auf den gegenüberliegenden Seiten der Taktscheibe angeordnet. Die erfindungsgemäße Schaltung für die Stabilisierung des Signals befindet sich einer in der Grundplatte G2.

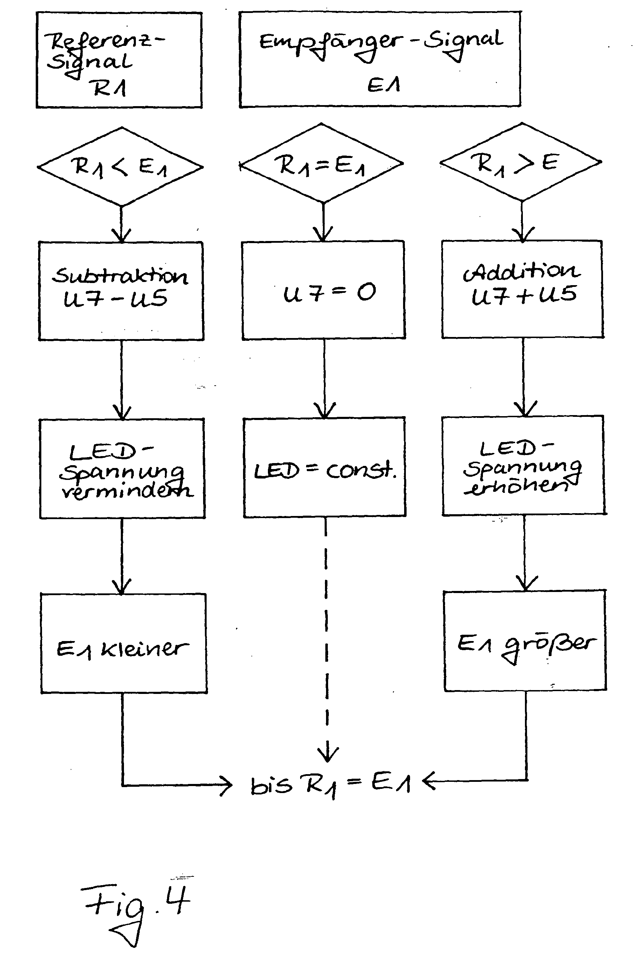

Anhand des Blockschaltbildes nach Figur 4 können die verschiedenen Situationen bei der Signalstabilisierung erläutert werden. Dabei wird ein Referenzsignal R1 gemäß Figur 2 und ein Empfängersignal E1 gegenübergestellt, dass aus der Sensoreinheit abgegeben wird. Im einfachsten Fall R1=E1 ist der Spannungsausgang des Verstärkers mit U7=0 angegeben. Dies bedeutet, dass die LED-Spannung konstant ist und somit keine Änderung erfolgt.

Ist das Empfängersignal E1 jedoch schwach, dann wird die Referenzspannung R1 größer als E1 und damit ein positives Ausgangsignal erzeugt, so dass U7 mit der Spannung U5 addiert wird. Damit erhöht sich die LED-Spannung, so dass die Lichtquelle stärker leuchtet. Als Ergebnis wird das Empfängersignal E1 vergrößert und zwar so lange, bis R1=E1 wird.

Im umgekehrten Falle, wenn das Referenzsignal R1 kleiner als das Empfängersignal E1 ist, wird die aus dem Verstärker ausgehende Spannung U7 negativ und von der Spannung U5 subtrahiert. Im Ergebnis wird damit die LED-Spannung vermindert und somit die Lichtintensität verkleinert. In der Folge verringert sich auch das Empfängersignal E1 und zwar so lange, bis R1=E1 ist.

Die vorbeschriebene Verfahrensvariante kann noch durch weitere Schritte ergänzt werden. So ist es zum Zwecke der Signalstabilisierung günstig, wenn das Ausgangssignal des Verstärkers U7 über eine Speichereinheit an den Minuseingang des Verstärkers zurückgeführt wird. Die Speichereinheit kann auch vorzugsweise in Form eines oder mehrerer parallel geschalteter Kondensatoren vorliegen.

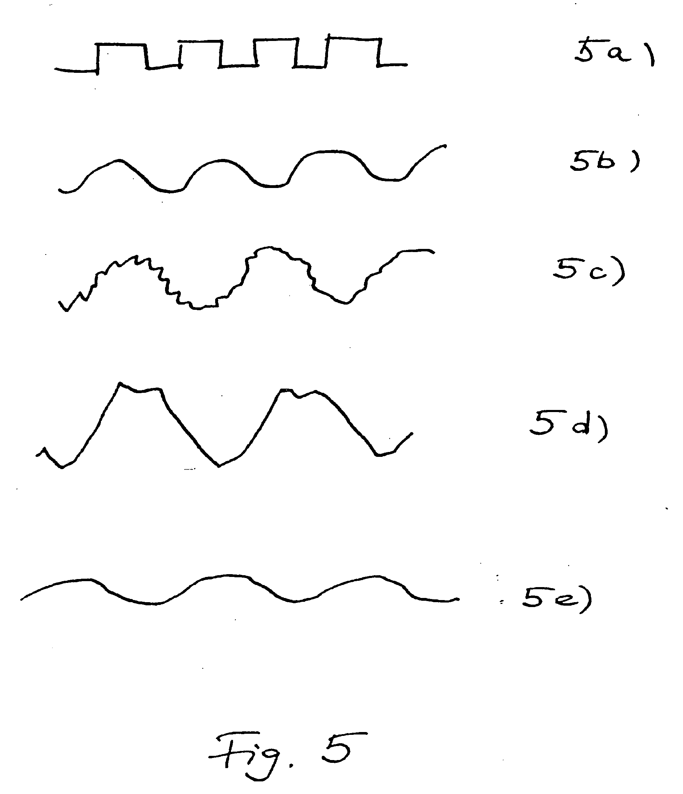

Eine weitere alternative Ergänzungsmöglichkeit bietet eine Verstärker- oder Transistorschaltung, bei der der Ausgang des ersten Verstärkers und die LED-Spannung auf den Plus- Minuseingang eines zweiten Verstärkers aufgeschaltet werden. Durch diese Schaltungsweise wird am Ausgang des zweiten Verstärkers eine Sinuskurve in Rechteckform erhalten (siehe Figur 5a) oben).

Ohne die erfindungsgemäße Schaltung zur Signalstabilisierung würde ein Signal gemäß Figur 5b) untere Kurve erhalten. Dieser Signalverlauf entspricht dem Stand der Technik und zeigt über den Kurvenverlauf verteilte Verzerrungen. Eine alterungsbedingte Frequenzschwankung und Amplituden-Änderung kann in einer komprimierten Form dargestellt werden. Unregelmäßigkeiten im mechanischen Teil des Encoders oder in den Reflektionszonen der Taktscheibe rufen jedoch starke Schwankungen in der Amplitude und in der Frequenz des Empfängersignals hervor. Diese Einflüsse sind schematisch in der Figur 5c) unten dargestellt.

## Patentansprüche

1. Verfahren zur Stabilisierung von optischen Signalen, die von einer LED erzeugt und in einem Empfänger in eine Spannung umgewandelt werden, wobei ein aus dem Empfänger abgeleitetes Spannungssignal in die Spannungsversorgung der LED (5) zurückgeführt und mit einer Referenzspannung verglichen wird,
wobei bei einer Unterschreitung der Referenzspannung die LED-Eingangsspannung erhöht und bei Überschreitung vermindert wird
unter Verwendung eines Differenzverstärkers und eines Vorschaltwiderstandes, dessen Widerstandsbeiwert so bemessen ist, dass bei einer negativen Spannung keine zusätzliche Spannung in die LED-Spannungsquelle geleitet wird während bei einer positiven Spannungsdifferenz die LED-Spannungsquelle um den betreffenden positiven Spannungswert erhöht wird, **dadurch gekennzeichnet, dass** die LED mit einer Taktscheibe/einem Taktlineal zu einer Sensor-EmitterEinheit eines Encoders zusammengeschaltet ist und das Signal (E1) aus dem Empfänger des Sensors (2) vor Einleitung in den Eingang eines Verstärkers (3) mit einer Referenzspannung (R1) verglichen wird und daraus eine Differenzspannung (U7) gebildet wird, die über die Feedback-Leitung (9) und über einen Speicher (8) an den Eingang des Verstärkers (3) zurückgeführt wird,
dass die Differenzspannung (U7) in einen zweiten Verstärker (4) eingegeben wird und dort mit einer zweiten Referenzspannung (R2) verglichen wird, die aus einer Addition der Differenzspannung (U7) mit einer Referenzspannung aus der LED (5) erzeugt wird und dass das aus dem Vergleich mit der zweiten Referenzspannung (R2) resultierende Signal (6) des Verstärkers (4) als Kontrollsignal für die Stabilisierung des Sensorsignals verwendet wird.

2. Vorrichtung zur Signalstabilisierung bei optischen Sensoren, die mit einer LED (5) und einer Taktscheibe/einem Taktlineal zu einer Sensor-Emittereinheit zusammengeschaltet sind, **dadurch gekennzeichnet, dass** die Leitung (1) des Empfängers des Sensors (2) mit dem ersten Eingang eines Verstärkers (3) verbunden ist, dessen zweiter Eingang an einer Referenzquelle (R1) angeschlossen ist, wobei der Verstärkerausgang (7) einerseits über eine Feedbackleitung (9) und einen Kondensator (8) an den ersten Eingang des Verstärkers (3) zurückgeführt ist und andererseits in den ersten Eingang eines zweiten Verstärkers (4) angeschlossen ist, dessen zweiter Eingang mit einer Referenzspannungsquelle (R2) verbunden ist, und dass die Ausgangsleitung (6) des zweiten Verstärkers (4) an eine Kontrolleinheit für das stabilisierte Sensorsignal angeschlossen ist.

## Claims

1. A method of stabilising optical signals which are generated by a LED and converted in a receiver into a voltage, wherein a voltage signal taken from the receiver is returned into the voltage supply means of the LED (5) and compared with a reference voltage, wherein the LED input voltage is increased if the reference voltage is not reached and decreased if it is exceeded, using a differential amplifier and an additional resistor whose resistance value is calculated in such a way that, in the case of a negative voltage, no additional voltage is conducted into the LED voltage source and that, in the case of a positive voltage differential, the LED voltage source is increased by the respective positive voltage value,
**characterised in**
**that** the LED is combined with an encoder disc/encoder ruler to form a sensor emitter unit of an encoder and that the signal (E1) from the receiver of the sensor (2), prior to being introduced into the input of the amplifier (3), is compared with a reference voltage (R1) and that, on the basis thereof, there is formed a differential voltage (U7) which, via a feedback line (9) and a memory (8) is returned to the input of the amplifier (3; and that the differential voltage (U7) is fed into a second amplifier (4) and, therein, compared with a second reference voltage (R2) which is generated by adding the differential voltage (U7) to a reference voltage from the LED (5); and that the signal (6) of the amplifier (4), which signal (6) results from the comparison with the second reference voltage (R2), is used as the control signal for stabilising the sensor signal.

2. A device for stabilising the signal in the case of optical sensors, which device which is combined with a LED (5) and an encoder disc/encoder ruler to form a sensor emitter unit,
**characterised in**
**that** the line (1) of the receiver of the sensor (2) is connected to the first input of an amplifier (3) whose second input is connected to a reference source (R1), wherein, on the one hand, the amplifier output (7) is returned to the first input of the amplifier (3) via a feedback line (9) and a condenser (8), and, on the other hand, connected into the first input of a second amplifier (4) whose second input is connected to a reference voltage source (R2); and that the output line (6) of the second amplifier (4) is connected to a control unit for the stabilised sensor signal.

## Revendications

1. Une méthode pour stabiliser les signaux optiques générés par une DEL et transformés en tension électrique dans un récepteur, par laquelle un signal de tension provenant du récepteur, sera renvoyé à l'alimentation en courant de la DEL (5) et comparé à une tension de référence, méthode selon laquelle la tension d'entrée de la DEL sera augmentée en cas de sous-dépassement de la tension de référence, et sera diminuée en cas de sur-dépassement, en utilisant un amplificateur différenciateur et une résistance intercalée en amont, dont le facteur de résistance est dimensionné de telle sorte qu'en cas de tension négative, la source de tension DEL ne sera pas chargée d'une tension supplémentaire, alors qu'en cas d'une tension de différence positive, la source de tension DEL sera augmentée de la valeur de tension positive en question, **caractérisé par le fait que** la DEL est connectée au bloc détecteur-émetteur d'un codeur par un disque de synchronisation ou une règle de synchronisation et que le signal (E1) provenant du récepteur du codeur (2), est comparé à la tension de référence (R1) avant l'admission à l'entrée d'un récepteur (3), et qu'il en résulte une tension de différence (U7) qui sera renvoyée via le conducteur de rétroaction (9) et via une mémoire (8) à l'entrée de l'amplificateur (3), que la tension de différence (U7) est transmise à un deuxième amplificateur (4) et comparée à une seconde tension de référence (R2) qui est formée par l'addition de la tension de différence (U7) et une tension de référence provenant de DEL (5), et que le signal (6), résultant de la comparaison avec la seconde tension de référence (R2) de l'amplificateur (4), sert de signal de contrôle pour la stabilisation du signal détecteur.

2. Un dispositif pour stabiliser un signal généré par détecteurs optiques qui est connecté à un bloc détecteur-émetteur par une DEL (5) et par un disque de synchronisation ou une règle de synchronisation, **caractérisé par le fait que** le conducteur (1) provenant du récepteur du détecteur (2) est connecté à la première entrée d'un amplificateur (3), dont la seconde entrée est raccordée à une source de référence (R1), en tenant compte d'une part, que la sortie (7) de l'amplificateur est reliée à la première entrée de l'amplificateur (3), via un conducteur de rétroaction (9) et un condensateur (8), et d'autre part, qu'elle est raccordée à la première entrée d'un second amplificateur (4), dont la deuxième entrée est reliée à une source de tension de référence (R2), et que le conducteur de sortie (6) du second amplificateur (4) est raccordé à une unité de contrôle pour le signal détecteur stabilisé.
